# EUROPEAN PATENT APPLICATION

(11) **EP 0 696 630 A2**
(43) Date of publication of application: **14.02.1996**
(21) Application number: 95303234.9
(22) Date of filing: 12.05.1995
(51) Int. Cl.: C09K 5/00

(54) **Heat conductive material and method for producing the same**

(30) Priority: 10.08.1994 JP 188607/94
(71) Applicant: FUJITSU LIMITED, Kawasaki-shi, Kanagawa 211 (JP)
(72) Inventor: Wakamura, Masato, c/o Fujitsu Limited, Kawasaki-shi, Kanagawa 211 (JP); Yamada, Mitsutaka, Nakahara-ki, Kawasaki-shi, Kanagawa 211 (JP); Yamaguchi, Joe, Nakahara-ku, Kawasaki-shi, Kanagawa 211 (JP); Hashimoto, Kaoru, Nakahara-ku, kawasaki-shi, Kanagawa 211 (JP)
(74) Representative: Silverman, Warren

(57) **Abstract**

A heat conductive material of high thermal conductivity contains a metal or an alloy which is liquid at room temperature or a fine powder of a heat conductive material dispersed in an organic material which is liquid at room temperature and is used as a cushioning contact material between electronic parts or a circuit substrate carrying electronic parts thereon and a cooling device for cooling the electronic parts or circuit substrate with electronic parts thereon.

## Description

This invention relates to a heat conductive material having good heat conductivity and to a method for producing the same, such heat conductive material being intended for cooling electronic parts, such as LSIs, chip condensers, chip resistors, etc., as well as circuit substrates with electronic parts thereon when being packaged.

Recently, as LSI chips, etc. have become more integrated and operate faster, the heat generated by the LSI chips has increased, and it has increasingly been required to cool positively the electronic parts. Presently, water cooling bellows or heat dissipation fins are provided on devices and substrates, or cooling channels are provided in circuit substrates, so as to decrease temperatures of the devices and substrates as much as possible.

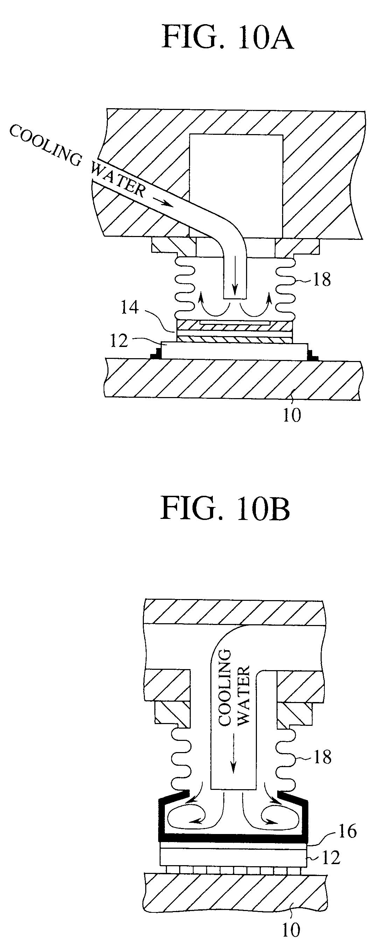

A conventional method for cooling electronic parts by means of a water cooling bellows will be explained with reference to FIGs. 10A and 10B of the accompanying drawings.

In the conventional practice, cooling of electronic parts has taken place using water cooling bellows 18 provided in intimate contact with or adhered to the upper surfaces of LSI chips 12 mounted on a circuit substrate 10 having an elastomeric heat conducting sheet 14 (Fig. 10A) or a thermal composition 16 (Fig. 10B) formed of a silicone rubber material intermediate therebetween. Thus a material of high thermal conductivity is inserted between the water cooling bellows 18 and the LSI chips 12 so that the efficiency of the heat dissipation/cooling is improved.

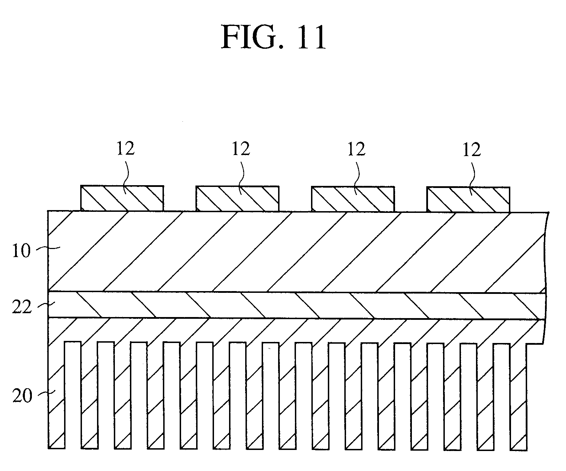

Fig. 11 of the accompanying drawings shows the cooling of circuit substrate 10 with a number of electronic parts mounted thereon, such as LSI chips 12, etc. A plurality of LSI chips 12 is mounted on the upper surface of the circuit substrate 10, and an array of heat dissipation fins 20 for radiating heat generated by the LSI chips is secured to the underside of the substrate 10 by an adhesion layer 22. In this case, as well as with the conventional arrangements of Fig. 10A or Fig. 10B, use is made of an adhesive (layer 22 in Fig. 11), or other material, with powder of a high heat conductive material distributed therein, for improving efficiency of the cooling.

The elastomeric heat conductive sheet 14, the thermal composition 16 and the adhesive layer 22 with powder of a high heat conductive material distributed therein all contain an organic resin as the base material. This is based on the following reason.

When the surfaces that the LSI chips 12 and the water cooling bellows 18 contact are rough, efficiency of the cooling deteriorates. A resilient material which can "flow" so as to fill in gaps in the interface between the LSI chip 12 and the water cooling bellows 18 and which can improve the intimacy of contact therebetween, is preferred. Because it is preferred, at the same time, that the heat conductive material returns to its original shape when removed, materials, such as metal, ceramics, etc., are not suitable, and organic polymers having rubber-like properties are suitable.

When an adhesive containing powder of a thermal composition 16 or a highly heat conductive material distributed therein is used, it is preferred that stresses due to thermal expansion differences between the members bonded by the adhesive be mitigated during heating/cooling, or when temperature increases occur when electronic apparatuses are being used. To this end, organic polymer materials, which can be bonded at low temperatures and can mitigate stresses after bonding as a result of their own flexibility are preferred.

A heat conductive material other than organic polymers is the heat conductive material described, for example, in Japanese Patent Laid-Open Publication No. 28264/1984, comprising a liquid silicone carrier and powder of a highly heat conductive material, such as AlN, mixed therewith for thermal conductivity improvement.

The heat conductive material described in Japanese Patent Laid-Open Publication No. 74503/1993 uses liquid metal which is liquid at room temperature to obtain high thermal conductivity.

While the cooling efficiency of such cooling devices has been improved, this has been in the context of electronic parts packaging methods replacing conventional soldering. When packaging electronic parts made by soldering, when the electronic parts and the circuit substrate have different heat expansion coefficients, stresses occur at the connections therebetween due to heating of the electronic parts during soldering and when operating, and in the worst cases the connections may break.

An electronic parts packaging method in which conventional soldering is replaced is described in, e.g., Japanese Patent Laid-Open Publication No. 190219/1993. This method uses liquid metal at connections between the electronic parts and the circuit substrate. According to this method, even when stresses are set up in the connections between the electronic parts and the circuit substrate due to the heat expansion coefficient difference between the two, the liquid metal at the connections sufficiently mitigates the stresses and the occurrence of breakage of the connections.

Moreover, the recent reduction in size and further development of electronic apparatuses has enabled electronic parts to be packaged with higher density, with the result that the heat generated per circuit substrate is drastically increased.

The conventional cooling methods for the electronic parts and the circuit substrates use adhesives of organic polymeric materials which do not have sufficient thermal conductivity and cannot provide sufficient heat dissipation.

In the method for producing a heat conductive material by mixing a finely divided highly heat conductive material, such as AlN, within a liquid organic material for improvement of heat conducting efficiency, it is difficult to distribute uniformly the fine powder, which tends to aggregate. Thus aggregates of the powder occur in the mixture, and bubbles are generated between bodies of aggregated material.

When using liquid metal as the heat conductive material, stresses generated between the cooling device and the adhered members can be mitigated. However, it is difficult to use liquid metal over a long period of time, as it tends to become oxidized, hydroxidized and corroded. The corroded liquid metal has lowered thermal conductivity and the cooling efficiency of the cooling device deteriorates. The same problem arises when packaging electronic parts using liquid metal, the liquid metal tends to be oxidized, hydroxidized and corroded. The liquid metal cannot be used stably for a long period of time and, when corroded, leads to drastically increased electrical resistance, and connections having increased contact resistance.

It is an object of this invention to find a new heat conductive material for reliable use in the aforementioned situations.

This invention provides a heat conductive material comprising:
an organic material which is liquid at room temperature; and either
(a) a metal or an alloy which is liquid at room temperature and which is distributed throughout the organic material; or
(b) fine powder of a highly heat conductive material dispersed in the organic material.

It is preferable that the volume percentage of the liquid metal or alloy or fine powder is within the range of 35-50 vol%.

In the above-described heat conducting material, it is preferable that the organic material is silicone oil, polyphenyl ether, or perfluoroalkyl polyether.

The metal or alloy which is liquid at room temperature is preferably gallium, a gallium-indium alloy, or a gallium-tin alloy. The fine powder of the highly heat conductive material is typically a fine powder of a metal or an alloy, such as aluminium, silver, copper, an aluminium alloy, a silver alloy, or a copper alloy. However, the fine powder may be formed of a different type of heat conducting material, such as aluminium nitride, boron nitride, or silicone carbide.

A method of producing such heat conductive material comprises:
a mixing step for mixing the metal or alloy which is liquid at room temperature, or the fine powder, with the organic material; and
a dispersing step for dispersing the liquid metal or alloy or the fine powder throughout the organic material.

For cooling electronic parts constituting an electric circuit, the electronic parts are placed in contact with a cooling device by means of a heat conductive material as above-described, and the electronic parts are cooled by operating the cooling device.

For cooling a circuit substrate with electronic parts packaged thereon, the circuit substrate is placed in contact with a cooling device by means of a heat conductive material, as above-described, and the circuit substrate is cooled by the operating the cooling device.

Finally, electronic parts may be supported when being packaged by forming connection pads on the surface of a circuit substrate and placing the connection pads in contact with connection terminals of the electronic parts by means of a heat conductive material as above-described.

According to one embodiment of the present invention, a liquid metal having thermal conductivity higher than a conventional organic polymeric material is mixed in a liquid organic material, whereby a heat conductive material having high thermal conductivity can be formed. The heat conductive material, in which the dispersed liquid metal is surrounded by the liquid organic material and shielded or protected from outside influences, can have good oxidation resistance and hydroxidation resistance and can retain high conductivity for a long time.

The heat conductive material, in which the liquid metal is uniformly distributed in the liquid organic material, is a viscous emulsion which adheres at room temperature to material to which it is applied. Its viscosity prevents its leaking from between an object to be cooled and the cooling device.

Parallel behaviour is observable when using a highly heat conductive fine powder having higher thermal conductivity than the conventional organic polymeric material mixed into the liquid organic material. The product itself can have high thermal conductivity. Such heat conductive material, in which the highly heat conductive fine powder is uniformly distributed in the liquid organic material without aggregation, and which becomes a viscous emulsion also adheres to substrates at room temperature and can have a viscosity such that it does not leak from between an object to be cooled and a cooling device.

Such second type of heat conductive material, in which the metal fine powder is surrounded by the liquid organic material and shielded from outside environments, can also have good oxidation resistance and hydroxidation resistance and can retain high thermal conductivity for a long time.

Owing to the elasticity or resilience of the heat conductive material, even when the interface between an object to be cooled and the cooling device is rough, the gaps in the rough interface can be filled with the result that heat can be efficiently conducted.

Furthermore, electronic parts, or a circuit substrate, and a cooling device can be adhered to each other by means of the heat conductive material of high thermal conductivity, whereby the cooling efficiency of the cooling device can be enhanced.

By connecting electronic parts to a circuit substrate using the emulsified connection material having high thermal conductivity, when the temperature of the electronic parts has risen, the connection material can absorb stresses at connections even in the presence of a heat expansion coefficient difference between the electronic parts and the circuit substrate. The connection material has some viscosity which prevents the heat conductive material from leaking from between the electronic parts and the circuit substrate. This combination of features enables packaging of electronic parts with reliable connections to circuit substrates to be realised.

The connection material which connects the circuit substrate and the electronic parts is a fluid composite material comprising the liquid metal, or fine conductive powder, and the liquid organic material, so that the connection material has large contact areas at the connections. Even when the connections are reduced in size, the electronic parts can be stably packaged. The liquid metal or fine powder, which is surrounded by the liquid organic material, is shielded from outside environments, and can have good oxidation resistance and hydroxidation resistance. Accordingly, the connection material can be used as a connection material of low electric resistance which can last for a long time.

In addition, the connection material which connects electronic parts and a circuit substrate is an emulsion, so that the electronic parts and the circuit substrate can be connected at room temperature without the need for any heating or cooling.

For a better understanding of the invention, and to show how the same may be carried into effect, reference will now be made to Figures 1-9C of the accompanying drawings, wherein:-
Figs. 1A and 1B show steps in the production of a heat conductive material embodying the present invention;
Fig. 2 is a schematic view of the cutter unit of a homogenizer used for producing the heat conductive material according to the present invention;
Fig. 3 is a diagrammatic view (in section) of a measuring device for measuring the cooling capacity of a heat conductive material according to the present invention;
Fig. 4 is a graph showing the relationship between surface temperature increase of a model chip and heating power output by a heater, incorporating/not incorporating a heat conductive material of a first type according to the present invention;
Fig. 5 is a graph showing the time dependence of the heat resistance of a heat conductive material of the first type according to the present invention when left in a humid environment;
Fig. 6 is a graph showing the relationship between surface temperature increase of a model chip and heating power output by a heater incorporating/not incorporating a heat conductive material of a second type according to the present invention;
Fig. 7 is a graph showing the relationships between surface temperature increase of a model chip and heating power output by a heater incorporating/not incorporating a heat conductive material of a third type according to the present invention;
Fig. 8 is a graph like that of Fig. 5 but produced for a heat conductive material of the third aforesaid type;
Figs. 9A to 9C show schematically the steps involved in packaging electronic parts using a heat conductive material embodying the present invention.

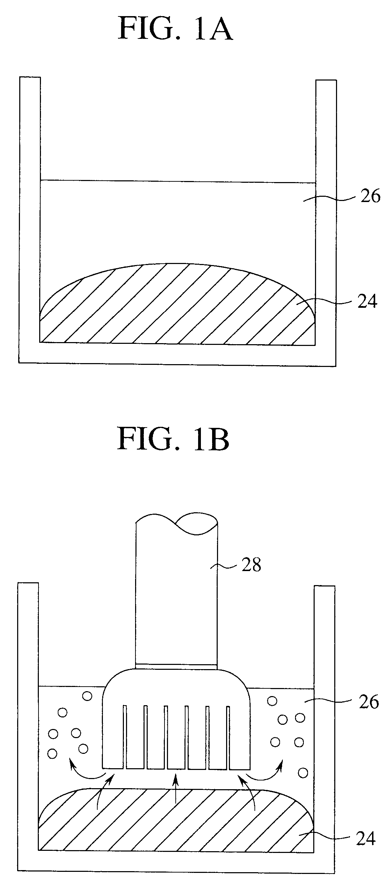

Referring to the drawings, Figs. 1A and 1B show steps in the production of a heat conductive material embodying the invention.

In this method, a liquid metal or a liquid alloy which is liquid at room temperature is distributed in a liquid organic material. The liquid metal may be a gallium (Ga)-indium (In) eutectic mixture, and the liquid organic material may be silicone oil.

A liquid Ga-In eutectic alloy 24 having a composition of 75.5 wt% of gallium and 24.5 wt% of indium is mixed with silicone oil 26 (Fig. 1A). Then, the Ga-In eutectic alloy 24 and the silicone oil 26 are sufficiently agitated by the homogenizer 28 which chops and mixes the sample (Fig. 1B).

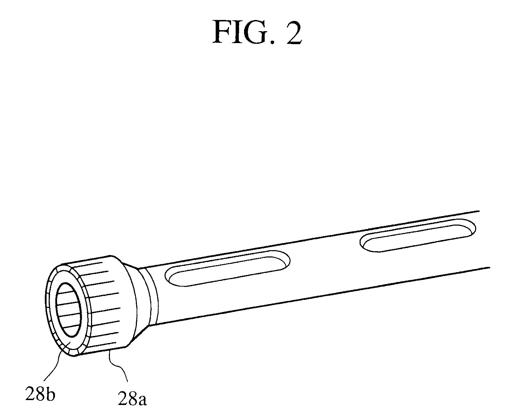

As shown in Fig. 2, the cutter unit of the homogenizer 28 comprises an outer cylindrical cutter 28a, and an inner cutter 28b inserted therewithin. When mixing the sample, the inner cutter 28b is rotated at high speed to draw the same into the opening in the centre thereof to be chopped and injected vertically downward.

The Ga-In eutectic alloy 24 is mixed with the silicone oil 26 by the homogenizer 28 to be distributed therein in the form of fine spherical particles, below about 1-µm in size. The heat conductive material thus prepared by the homogenizer 28 is an emulsion, and has a viscosity which prevents the heat conductive material from leaking from between an object to be cooled and a cooling device.

When the Ga-In eutectic alloy 24 is mixed with the silicone oil 26 in a small amount, the thermal conductivity is unsatisfactory, and the silicone oil 26 and the Ga-In eutectic alloy 24 separate easily from each other. When the Ga-In eutectic alloy 24 is mixed with the silicone oil 26 in a large amount, the heat conductive material produced is clay-like. To prepare the heat conductive material as an emulsion it is preferred that the Ga-In eutectic alloy 24 and the silicone oil 26 are mixed in substantially equal amounts.

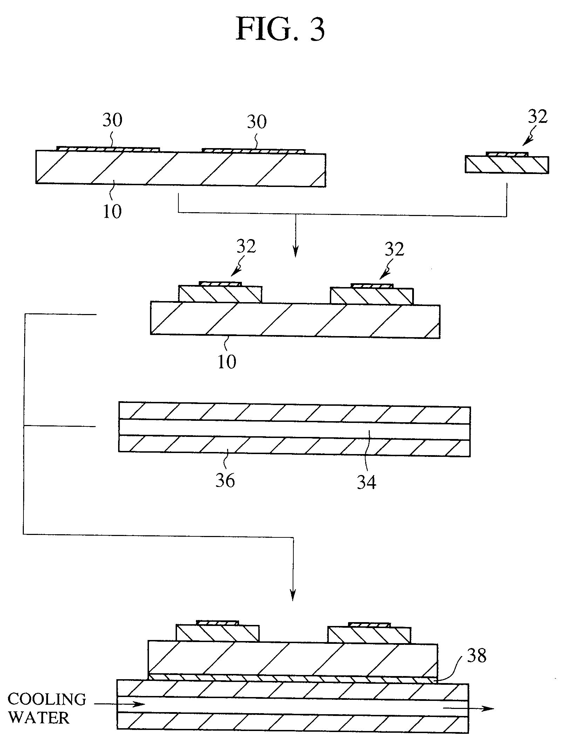

The thermal conductivity of the thus-prepared heat conductive material was evaluated by the measuring device shown in Fig. 3.

Model chips 32 of silicon each with a resistance heater built in are soldered onto a circuit substrate 10 formed of alumina and having metallized layers 30 for connecting electronic parts formed thereon. Then a cooling device 36 having a cooling channel 34 therein is put into contact with the underside of the circuit substrate 10 with the heat conductive material 38 intermediate therebetween.

In this state, cooling water is passed through the cooling channel 34 of the cooling device 36 while a current is applied to a heater (not shown) built into the model chip 32, and surface temperature increases of the model chip 32 are measured. In this state, the heat conductive material 38 is left at 60°C in a humid environment of 85%RH, and the transient thermal resistance of the heat conductive material is measured.

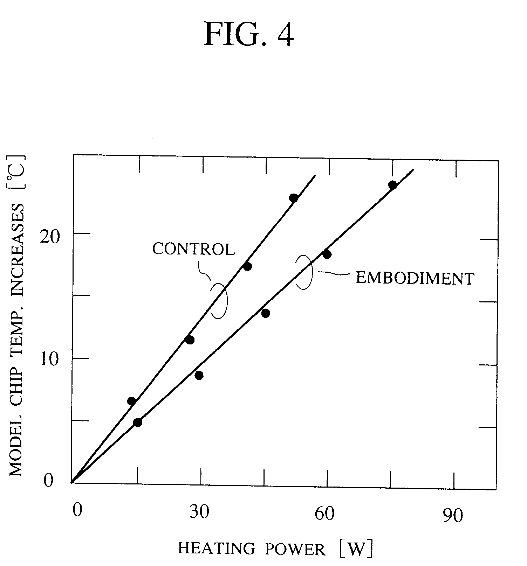

Fig. 4 is a graph of relationship between surface temperature increases of the model chip 32 and the power output of the heater determined according to Fig. 3. In the control in Fig. 4, a commercially available thermal composition 16 was used as the heat conductive material 38. As shown in Fig. 3, the cooling device 36 was made to contact the circuit substrate 10 with the heat conductive material 38 of the present embodiment intermediate the two. In this way, device temperature increases could be reduced in comparison with those of the control using the thermal composition 16, for the same amount of heat energy from the heater. That is, the use of the heat conductive material 38 which was an emulsion and had high thermal conductivity improves the thermal conductivity and cooling efficiency.

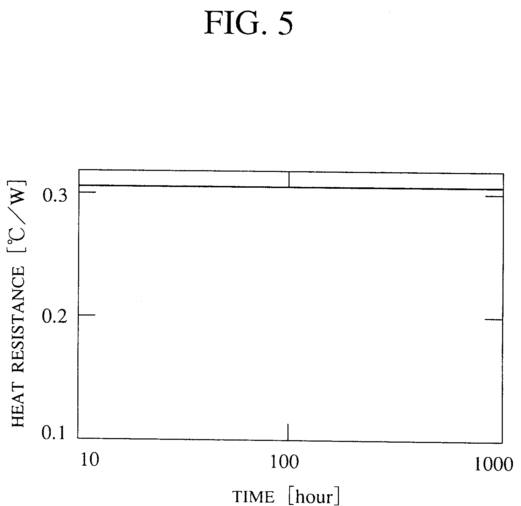

Fig. 5 is a graph of the time dependence of the heat resistance of the model chip 32 when the model chip 32 is left in a humid environment. The heat resistance of the heat conductive material 38 according to the present embodiment does not change even after the material 38 had been left in the humid environment for 1000 hours. Thus, the Ga-In eutectic alloy 24 is not oxidized or hydroxidized even in a humid environment, and retains heat dissipation efficiency.

Thus, according to the present embodiment, a Ga-In eutectic alloy 24, which is a liquid metal having higher thermal conductivity than the conventional organic polymer material, is mixed in silicone oil 26 as a liquid organic material, whereby the heat conductive material 38 having good thermal conductivity can be prepared.

In so doing, the mixed Ga-In eutectic alloy 24 is surrounded by the silicone oil 26 and is isolated from an outside environment so that the alloy 24 has good oxidation resistance and hydroxidation resistance, and the heat conductive material 38, whose high thermal conductivity can be sustained for a long period of time, can be produced.

As stated, to mix the Ga-In eutectic alloy 24 in silicone oil, use may be made of an homogenizer, and the thus-prepared heat conductive material is a fairly viscous emulsion. Accordingly, the heat conductive material adheres to a substrate and can be prevented from leaking from between an object to be cooled and the cooling device.

When the interface between an object to be cooled and the cooling device is rough, the elasticity of the heat conductive material is such that it enter depressions in the rough interface, whereby heat can be efficiently conducted away.

In the practice of the present invention the liquid metal is preferably a Ga-In eutectic alloy, but may be another liquid metal. For example, gallium metal and Ga-Sn alloys may be used, and the same effects can be achieved. The liquid organic material was a silicone oil, specifically silicone oil 26, but polyphenyl ether and perfluoroalkyl polyether may be used.

For example, when a eutectic alloy comprising Ga (92 wt%) and Sn (8 wt%) was used as the liquid alloy, and was mixed with an organic liquid by the homogenizer, then the liquid metal was distributed in the organic liquid in fine spherical particles, below 1-µm in size. It was found that when the liquid alloy was employed in the organic liquid to 88 - 99 vol%, the resistance value of the heat conductive material was substantially the same as that of liquid metal, but the resistance value increased as the volume% decreased, and the resistance value exceeded 100 mΩ when the volume% was below 55 vol%. The composite material was neither oxidized nor hydroxidized when it was left in an 85% RH (relative humidity) atmosphere.

A second type of heat conductive material embodying this invention will now be described with reference to Figs 2, 3 and 6 with only features distinct from those already discussed being described in detail.

The second type of heat conductive material according to the present embodiment is characterized in that a finely divided non-metallic material of high thermal conductivity is distributed in a liquid organic material. Such material of high thermal conductivity is preferably aluminium nitride (AlN), and the liquid organic material is silicone oil. AlN has a thermal conductivity as high as about 150 - 200 W/m.K.

In the same way as with the first type of high thermal conductivity material, the composite material comprising 70 wt% of AlN fine powder and 30 wt% of silicone oil 26 was sufficiently mixed by a homogenizer 28. It is difficult to distribute fine powder uniformly, since it generally tends to aggregate, but the use of the homogenizer 28 prevents formation of aggregates of the fine powder and bubbles. The heat conductive material thus prepared by the homogenizer 28 is an emulsion and is viscous to prevent loss of the heat conductive material from between an object to be cooled and the cooling device. The heat conductive material is free from deterioration due to long term use.

Such heat conductive material according to the present embodiment comprises a highly heat conductive fine powder mixed in with the liquid organic material, and can be easily removed by a common solvent, such as ethanol.

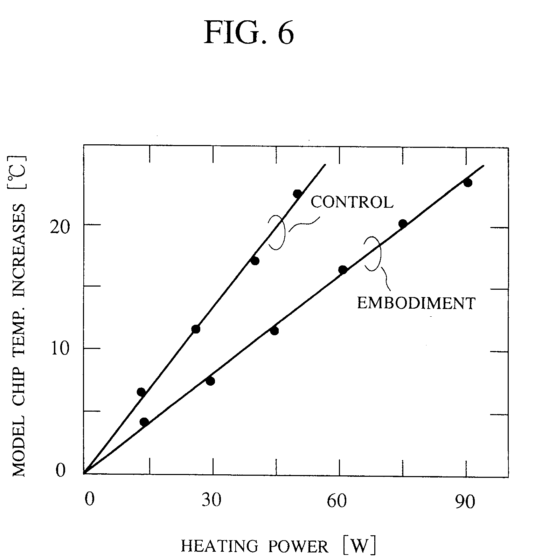

Fig. 6 shows the relationship between surface temperature increase and heating power output of the heater for this second type of heat conductive material determined according to the method described with reference to Fig.3. The heat conductive material 38 was used with a control which was a commercially available thermal composition 16. As described in connection with Fig. 3, the cooling device 36 was placed in contact with the circuit substrate 10, with the heat conductive material 38 intermediate therebetween. It was found again that device temperature increases could be reduced in comparison with those of the control using the thermal composition 16 for the same amount of heating energy from the heater. That is, the use of the heat conductive material 38 which was an emulsion and had high thermal conductivity could improve the thermal conductivity and cooling efficiency.

Because of the high electric insulation of the fine AlN powder, which is a highly heat conductive fine powder, the heat conductive material causes no short circuit.

As an alternative to using AlN powder for the highly heat conductive fine powder, other highly heat conductive fine powders may be used, for example, hexagonal boron nitride (BN) of about 100 - 300 W/m.K thermal conductivity and silicon carbide (SiC) of about 270 W/m.K thermal conductivity. The same effects can be achieved thereby. The liquid organic material was again silicone oil 26, but may be polyphenyl ether and perfluoroalkyl polyether.

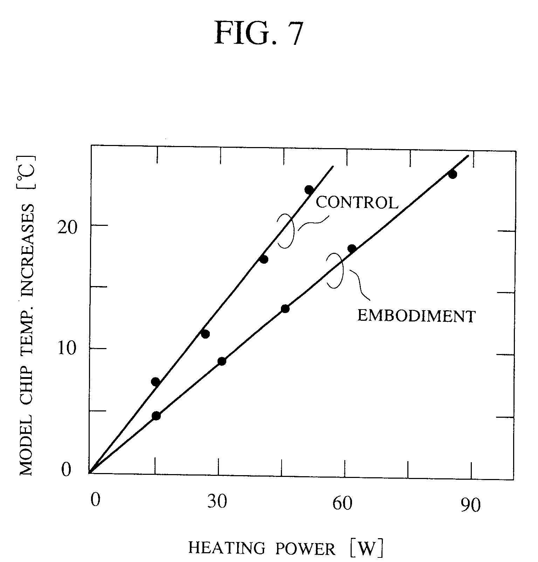

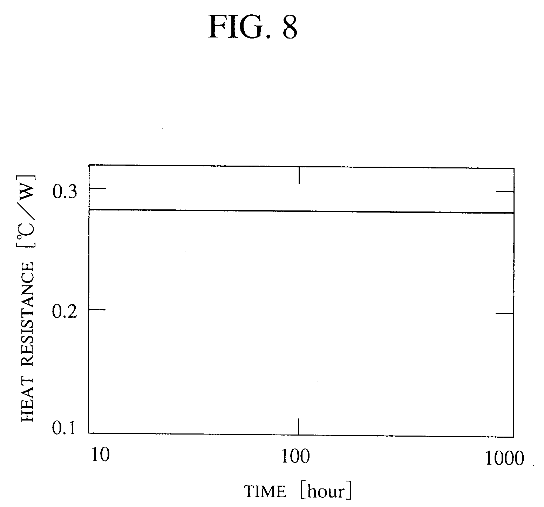

Fig. 7 and Fig. 8 parallel Fig. 4 and Fig. 5 respectively as to the types of information conveyed. Here, the material of high thermal conductivity distributed in a liquid organic material is metal powder or alloy powder. The metal powder is preferably aluminium (Al), and the liquid organic material may be silicone oil. Aluminium is a material which exhibits a high thermal conductivity, as high as about 200 W/m.K.

In the same way as with the previously described heat conductive material embodying this invention, Al powder and silicone oil 26 were sufficiently mixed by the homogenizer 28. The heat conductive material prepared by means of the homogenizer 28 was an emulsion sufficiently viscous not to leak between an object to be cooled and a cooling device 36.

When the metal powder and the liquid organic material are mixed, because the specific gravities of the metal powder and the liquid organic material differ significantly, when the mixture is left for a long time, the metal powder and the liquid organic material separate from each other. However, by the use of the homogenizer 28, the heat conductive material 38 is produced as an emulsion in which the metal powder remains uniformly dispersed in the liquid organic material for a long time.

The thermal conductivity of the thus-prepared heat conductive material 38 was evaluated by the measuring device shown in Fig. 3.

Fig. 7 shows the relationship between surface temperature increases of the model chip 32 and heating power output from the heater. In the control in Fig. 7, the heat conductive material 38 is a commercially available thermal composition 16. The cooling device 36 is placed in contact with a circuit substrate 10 via the heat conductive material 38 produced according to the present embodiment (using the thermal composition 16, for control purposes). The device temperature increases could be kept small for the same amount of heating energy when using heat conductive material 38. That is, by the use of the heat conductive material 38 which is an emulsion and has good thermal conductivity, improved thermal conductivity and improved efficiency of the cooling device 36 can be achieved.

Fig. 8 shows the time dependence of the heat resistance of the model chip when the model chip 32 was left in a humid environment equivalent to that determined for the first described heat conductive material 38 according to the present embodiment. There was no change in heat resistance even after being left for 1000 hours in the humid environment. Thus, in a humid environment, oxidation and hydroxidation of the Al fine powder do not take place and the heat dissipation efficiency can be maintained.

Thus, fine Al powder, which is a fine metal powder superior in thermal conductivity to the conventional organic polymer material, is mixed with silicone oil 26, to produce material 38 which can have good thermal conductivity. In addition, the mixed Al fine powder is surrounded by the silicone oil 26 and shielded from an outside environment, so that the heat conductive material 38 has good oxidation resistance and hydroxidation resistance. The material 38 has a high thermal conductivity which can be sustained for a long period of time. Other metals than Al can also be used. For example, the same effect can be produced by using fine powder of copper (Cu), whose thermal conductivity is about 450 W/m.K, or silver (Ag), whose thermal conductivity is about 500 W/m.K. The liquid organic material again may be polyphenyl ether or perfluoroalkyl polyether as an alternative to silicone oil.

With the various forms of material embodying this invention, the resilience of the heat conductive material 38 enables it to fill the gaps between an object to be cooled and the cooling device 36 even when the interface between the two is rough. Heat can be efficiently conducted away.

When the heat conductive materials 38 according to the various embodiments described above are provided between the circuit substrate 10 and the cooling device 36, higher cooling efficiency is achieved when both are adhered to each other. Higher cooling efficiency can be obtained by using the heat conductive material 38 according to the present embodiment between parts where high thermal conductivity is required. Parts where the heat conductive material is used are not limited to such parts. For example, to directly cool an LSI chip, the heat conductive material may be provided between the water cooling bellows 18 and the LSI chip 12.

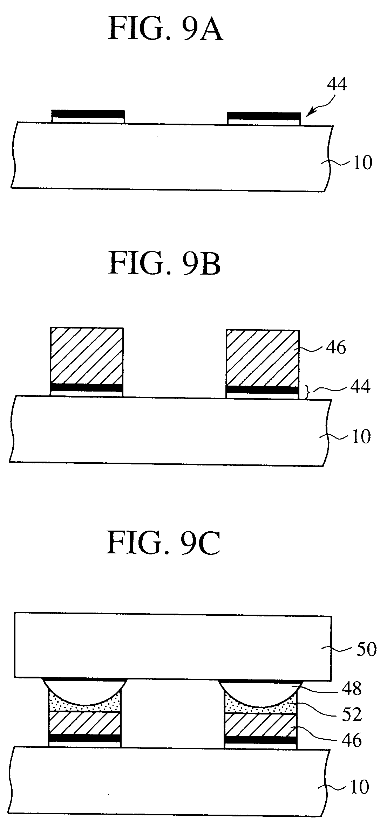

Finally, a method for packaging electronic parts embodying the present invention will be explained with reference to Figs. 9A to 9C.

A method for packaging electronic parts embodying the present embodiment is shown in Figs. 9A to 9C to involve connecting electronic parts 50 to studs 46 formed on a circuit substrate 10 using a connection material 52 comprising a liquid metal and a liquid organic material intermediate therebetween.

Thus, as shown in Figs. 9A and 9B, connection pads 44 having a two-layer structure of nickel (Ni) and chromium (Cr) are formed on a circuit substrate 10 of alumina (Al₂0₃/Cr/Ni structure) on which electronic parts are to be packaged. Studs 46 with Ni wire thermo-compression bonded or ultrasonically bonded thereon are formed on the connection pads 44. Electronic parts 50 having rounded connection terminals 48 are to be electrically connected to such a circuit substrate by the connection material 52 comprising a liquid metal and a liquid organic material.

In greater detail, first, the connection pads 44 having a two-layer structure of Ni and Cr in a 150 µm-diameter are formed on the circuit substrate 10 of alumina (Fig. 9A). Ni wire of 100 µm-diameter is thermo-compression bonded or ultrasonically bonded onto the connection pads 44 by a wire bonder, and the studs 46 are formed (Fig. 9B).

The electronic parts 50 with the rounded connection terminals 48 formed on the underside thereof are electrically connected through the connecting material 52 of an electrically conducting heat conductive material (Fig. 9C) to the thus-prepared studs 46 formed on the circuit substrate 10. The heat conductive material used is typically prepared by mixing liquid Ga-In eutectic alloy 24 (75.5 wt% of gallium (Ga) and 24.5 wt% of indium (In) with silicone oil 26 as described hereinbefore with reference to Figs. 1 and 2.

In this state, electric resistances of the parts connected through the connection material 52 are measured. Transient electric resistances are measured in a humid environment of 40 °C and 85 %RH. In a control, the same measurement is conducted on a sample in which the electronic parts were connected by only the liquid metal (Ga-In alloy) without the liquid organic material mixed in.

The electric resistances at the connection points were about 10 mΩ in both the present embodiment, where the mixture of the liquid metal and the liquid organic material was used as the connection material, and with the control, with the liquid metal alone. After being left for 200 hours in a humid environment, the electric resistance rose in the control where the electronic parts were connected with the liquid metal alone, to values ranging to several Ω. On the other hand, in the present embodiment where the Ga-In containing liquid was used, the electric resistance did not change even after leaving the joint for 1000 hours in the humid environment.

This is because the liquid metal alone, is not being shielded from outside environments, is progressively hydroxidized, and deformed and solidified. In the practice of the present invention, in which the liquid metal is surrounded by the liquid organic material, the liquid metal is not deformed in a humid environment, and retains low electric resistance for a long time.

Thus, in the practice of the present invention, because the electronic parts 50 are electrically connected to the circuit substrate 10 by the emulsified connection material 52 having high thermal conductivity, even when there is a heat expansion coefficient difference between the electronic parts 50 and the circuit substrate 10, the connection material 52 can absorb stresses at the connections. The connection material 52 has some viscosity which prevents the material 52 from leaking from between the electronic parts 50 and the circuit substrate 10. Therefore, overall, the connections are more reliable.

The connection material 52 which connects the circuit substrate 10 and the electronic parts 50, is a liquid composite material comprising the liquid metal and the liquid organic material, so that the connection material 52 has large contact areas at the connections. Even when the connections are reduced in size, the electronic parts can be stably packaged. The liquid metal, which is surrounded by the liquid organic material, is secluded from external influences, and can have oxidation resistance and hydroxidation resistance. Accordingly the connection material of low electric resistance can be used for a long time.

The connection material 52, used between the electronic parts 50 and the circuit substrate 10 is an emulsion, and can connect the electronic parts 50 and the circuit substrate 10 at room temperature without heating or cooling.

In the embodiment described with reference to Figs. 9A and 9C, the liquid metal was the Ga-In eutectic alloy 24, but may be other liquid metals, metal powder or other substances such as described may be employed in the organic liquid. For example, the same effect can be achieved by using metal gallium, Ga-Sn alloys, metal powders, as of aluminium, silver, copper, etc. The liquid organic material was silicone oil, but typically may be polyphenyl ether or perfluoroalkyl polyether.

## Claims

1. A heat conductive material comprising:
an organic material which is liquid at room temperature; and either
(a) a metal or an alloy which is liquid at room temperature and which is distributed throughout the organic material; or
(b) fine powder of a highly heat conductive material dispersed in the organic material.

2. A heat conductive material according to claim 1, wherein the volume percentage of the liquid metal or alloy or of the fine powder is within the range of 35-50 vol%.

3. A heat conductive material according to claim 1 or 2, wherein the organic material is silicone oil, polyphenyl either, or perfluoroalkyl polyether.

4. A heat conductive material according to any preceding claim, wherein the metal or the alloy is gallium, a gallium-indium alloy, or a gallium-tin alloy.

5. A heat conductive material according to any one of claims 1 to 3, wherein the fine powder of the highly heat conductive material is fine powder of a metal or an alloy.

6. A heat conductive material according to claim 5, wherein the metal or alloy is selected from aluminium, silver, copper, an aluminium alloy, a silver alloy, or a copper alloy.

7. A heat conductive material according to any one of claims 1 to 3, wherein the fine powder of the highly heat conductive material is fine powder of aluminium nitride, boron nitride, or silicon carbide.

8. A method for producing the heat conductive material of any preceding claim comprising:
a mixing step for mixing the metal or alloy which is liquid at room temperature, or the fine powder, with the organic material; and
a dispersing step for dispersing the liquid metal or alloy or the fine powder throughout the organic material.

9. A method for cooling electronic parts within an electric circuit, comprising placing the electronic parts in contact with a cooling device by means of a heat conducted material according to any one of claims 1-7 and cooling the electronic parts by operation of the cooling device.

10. A method for cooling a circuit substrate with electronic parts packaged thereon, comprising placing the circuit substrate in contact with a cooling device by means of a heat conducted material according to any one of claims 1-7 and cooling the circuit substrate by operation of the cooling device.

11. A method of supporting electronic parts when packaging them, which comprises forming connection pads on the surface of a circuit substrate, and placing the connection pads in contact with connection terminals of the electronic parts by means of a heat conductive material according to any one of claims 1-7.
